**Europäisches Patentamt**

**European Patent Office**

**Office européen des brevets**

(19)

(11) Publication number : **0 234 070 B1**

# EUROPEAN PATENT SPECIFICATION

(12)

(45) Date of publication of patent specification :
**07.12.94 Bulletin 94/49**

(51) Int. Cl.⁵ : **H03M 5/08, H03M 5/14,**
**// H04L25/49**

(21) Application number : **86301164.9**

(22) Date of filing : **19.02.86**

(54) **Apparatus for fixed-length binary encoding and decoding.**

(30) Priority : **13.02.86 US 829288**

(43) Date of publication of application :
**02.09.87 Bulletin 87/36**

(45) Publication of the grant of the patent :
**07.12.94 Bulletin 94/49**

(84) Designated Contracting States :
**BE CH DE FR GB IT LI NL SE**

(56) References cited :
EP-A- 0 171 948
DE-B- 1 152 277
US-A- 3 597 752
US-A- 3 633 190
US-A- 3 882 301
IBM TECHNICAL DISCLOSURE BULLETIN.
vol. 26, no. 7A, December 1983, NEW YORK US
pages 3479 - 3480; I.HERNANDEZ: "Coding
scheme in proportional encoding"

(56) References cited :
IEEE TRANSACTIONS ON INFORMATION
THEORY. vol. IT-11, no. 2, April 1965, NEW
YORK US pages 284 - 292; W.H.KAUTZ:
"Fibonacci codes for synchronization con-
trol"
IBM TECHNICAL DISCLOSURE BULLETIN.
vol. 9, no. 10, March 1967, NEW YORK US
pages 1318 - 1319; M.PADALINO:
"Intelligence storage -or communication- sys-
tem"
IBM TECHNICAL DISCLOSURE BULLETIN.
vol. 15, no. 9, February 1973, NEW YORK US
page 2809 J.LEYBOURNE: "Method for print-
ing delta distance code"

(73) Proprietor : **KRONOS, INC.**
**62, 4th Avenue**
**Waltham Massachusetts02154 (US)**

(72) Inventor : **Krakauer, Lawrence**
**15 Orchard Lane**
**Wayland Massachusetts (US)**
Inventor : **Baxter, Larry**
**18 Hancock Street**
**Lexington Massachusetts (US)**

(74) Representative : **Allsop, John Rowland et al**
**European Patent Attorney**
**10 London End**
**Beaconsfield, Bucks. HP9 2JH (GB)**

EP 0 234 070 B1

## Description

The present invention relates to binary data encoding and reading, being more particularly directed to the conversion of coding by a weighted code to a continuous numerical sequence, particularly useful for single track encoding and reading as on linear media and the like, such as optically readable bars or marks, time cards, magnetic strips, tapes or discs and, more generally, for data transmission purposes as well.

Recording media of the above and similar types each have a smallest resolvable unit which shall herein be termed a "cell"; the cell size in magnetic media being set by the maximum number of feasible flux changes per inch, or the smallest black or white bar that can be resolved in optical media. Of particular concern to the present invention are media or channels that have no separate clock signal (such as, for example, the striped or barred time cards of our prior U.S. Letters Patent Nos. 4,270,043 and 4,361,092), so that the bits recorded thereon must somehow be self-clocked.

Among the prior techniques for accomplishing this purpose is so-called Manchester-encoding, also called phase-encoding, using a transition from, say, high logic level to low logic level as a binary "1" and the converse as a "0", with the period between transitions constituting the "cell".

Each bit uses two cells, with a data transition at the end of the second cell, so there is always a "clock" transition at least every other cell. An insignificant transition is added at the end of the first cell if needed to cause the following data transition to go in the proper direction. These and related coding schemes are described, for example, in the following references: Digital Magnetic Tape Recording for Computer Applications, L.G. Sebestyen, Chapman and Hall Ltd., London (1973), Distributed in U.S. by Halsted Press, a division of John Wiley and Sons, New York (Library of Congress Catalogue Card 73-6263); see section 5.2, "Encoding and Decoding"--general comparison of various encoding schemes; ANSI Standard X3. 48-1977, American National Standards Institute, 1430 Broadway, New York, N.Y. 10018--ANSI standard for Manchester Phase Encoding on Full-Size Cassettes; "Digital Recording in Low-Cost Transports", Clark E. Johnson, Jr., Digital Design, June 1977, pp. 38-48--general comparison of various encoding schemes; and "Pulse Codes in Serial Data Communications", Lester S. Sanders, Computer Design, January 1982, p. 203.

Another closely related scheme is "Frequency Modulations", in which there is a "clock" transition at the end of the first cell (between data bits), with a transition at the end of the second cell constituting a "1", and no transition representing a "0". This type of technique is described in the Johnson and Sanders articles, above mentioned, and in "Simple Encoding Schemes Double Capacity of a Flexible Disc", David J. Kalstrom, Computer Design, September 1976, pp. 98-102--MFM (Modified Frequency Modulation), MMFM (Modified, Modified, Frequency Modulation), and GCR (Group Coded Recording).

In the above schemes, the data density is 0.5 bits per cell, and there is always a transition (a "clock" transition used to resynchronize the reader or receiver) at least every two cells.

Another approach called "group encoding", or "run-length coding", involves groups of four bits encoded into 5-bit "run-length" codes, such as:

TABLE I

| Data | Code | Data | Code |
|------|------|------|------|
| 0000 | 11001 | 1000 | 11010 |
| 0001 | 11011 | 1001 | 01001 |
| 0010 | 10010 | 1010 | 01010 |
| 0011 | 10011 | 1011 | 01011 |
| 0100 | 11101 | 1100 | 11110 |
| 0101 | 10101 | 1101 | 01101 |
| 0110 | 10110 | 1110 | 01110 |
| 0111 | 10111 | 1111 | 01111 |

The run-lengths codes described in the Kalstrom article, above, and in "Group-Coded Recording Reliably Doubles Diskette Capacity", Pawitter S. Sidhu, Computer Design, December, 1976, pp. 84-88--GCR (Group Coded Recording), are carefully chosen so that there are never more than two zeros in a row, even when two codes are concatenated. The codes are then sent using transitions for "1"s and no transitions for "0"s, as in Manchester, but without the intervening "clock" transitions. For example:

```
Original Data:      0 0 1 1   0 1 0 0

Run-Length Code:    1 0 0 1 1 1 1 1 1 0 1
```

It may be noted that up to 3 cells between transitions are possible and that this method uses only 5 cells for 4 bits, for a bit density of 0.8 bits/cell--a 60% improvement over phase or Manchester encoding. There may, however, be up to a 3-cell maximum gap in the previously described methods. In media with poor speed control, this may be critical, and sometimes cannot be tolerated.

Other methods, such as Modified Frequency Modulation (MFM or MMFM) (see the Kalstrom article, supra, and "Second Generation Disc Read/Write Electronics", Robert M. Batey and James D. Becker, Hewlett Packard Journal, January, 1984, pp. 7-12 (describes VLFM, a variant of MFM and MMFM), also increase the bit density, but similarly at the expense of longer periods without a transition to synchronize the receiver or reader.

Another coding scheme called "Variable Cell Width" (VCW) is of particular interest here, since it introduces the idea that data "1's" and data "0's" need not be the same length, (see Johnson article, supra, and "A Compact Tape Transport Subassembly Designed for Reliablility and Low Cost", Douglas J. Collins and Brian G. Spreadbury, Hewlett Packard Journal, Jully, 1980, pp. 14-19--VCW encoding (Variable Cell Width), also called a "Delta-distance Code"). In this technique, data "1's" are longer than data "0's", so that although the average data packing density is increased (if the data have an even number of "1's" and "0's" on the average), individual record lengths will vary based on the ratio of "1's" to 0's". This is considered a major shortcoming of this technique.

Underlying the present invention is the discovery that a previously recognised mathematical oddity (the so-called Fibonacci number--Mathematical Circus, Martin Gardner, Alfred A Knopf, Inc, New York (1979) ISBN 0-394-50207-8, Chapter 13, "Fibonacci and Lucas Numbers", pp. 152-168; and The Fibonacci Quarterly, Published by "The Fibonacci Association", University of Santa Clara, Santa Clara, California 95053, --) may be developed into a weighting code for use with a raw code of variable length, converting the same into a continuous numerical sequence that, while having the noise immunity of Manchester coding and Frequency Modulation, startlingly provides substantially one-third greater bit density than such prior codes and obviates other limitations thereof. The "Fibonacci numbers " are a series in which each succeeding term is obtained by adding the previous two terms:

$$n: \quad 0 \quad 1 \quad 2 \quad 3 \quad 4 \quad 5 \quad 6 \quad 7 \quad 8 \quad 9 \ldots$$

$$Fib(n): \quad 1 \quad 1 \quad 2 \quad 3 \quad 5 \quad 8 \quad 13 \quad 21 \quad 34 \quad 55 \ldots$$

In this connection, the applicant also directs the reader as representative prior art to its co-relating European patent publication EP-A-0 171 948, published on 19. 02. 86, which discloses a method of adapting Fibonacci number weighting to raw binary code data of variable length to use the code as a fixed length code. This is done by using only those code sequences with a fixed number of cells rather than a fixed number of bits, converted the code to a continuous numerical sequence useful particularly for linear media and data transmission.

An object of the present invention is to provide a new and improved method of binary code storage or encoding that enables such greater bit density.

A further object is to provide novel apparatus particularly suited to the utilisation of such improved coding employing Fibonacci numbers.

Still another object is to provide novel encoder and decoder apparatus for use with such Fibonacci codes.

Other and further objects will be explained hereinafter and are more particularly delineated in the appended claims.

According to one aspect of the invention there is provided data encoding apparatus comprising clocking means for providing clocking pulses at predetermined frequencies, computer controlled next-word register

EP 0 234 070 B1

means for storing bit words to be encoded, accumulator register means for receiving a word to be encoded from the next-word register means, multiplexor means for transferring a bit word held in the next-word register means to said accumulator register means in response to a clocking pulse applied thereto at the end of a previously encoded word, Fibonacci number generator means for generating sequentially lowering Fibonacci numbers from a pre-set highest Fibonacci number in response to a clocking pulse of said clocking means, subtractor means for comparing the current Fibonacci number with the current contents of the accumulator register means at each clock cycle so that if the current contents of the accumulator register means is higher than the current Fibonacci number, the accumulator register means is clocked by said clocking means through first and second gate means so that the current Fibonacci number is subtracted from the current contents of the accumulator register means and an associated first flip-flop is clocked by said clocking means to produce a coded one that is one cell long in Fibonacci code sequence, said subtractor means providing a first output inhibitor signal via said first gate means to prevent the accumulator register being clocked by a subsequent clock pulse if the current number in the accumulator register means is smaller than the current Fibonacci number and to set a second flip-flop causing same to send a second inhibitor signal via said first gate means to prevent the accumulator register being clocked on the following clock pulse and such that said first flip-flop means is clocked by said clocking means to produce coded zeros that are two cells long in Fibonacci code sequence.

According to another aspect of the invention there is provided data decoding apparatus comprising circuit means for receiving a message encoded in Fibonacci code sequence wherein received zero bits are two cells long and one bits are one cell long and generating in response thereto a first pulsed signal containing a single pulse for each one bit received and two pulses during a zero bit, and a second pulsed signal containing a single pulse at the conclusion of each one bit in the input stream, Fibonacci number generator means operable in response to the first pulsed signal to generate sequentially decreasing Fibonacci numbers from a preset highest number to a preset lowest number, accumulator register means operable in conjunction with adder means for adding a Fibonacci number in the decreasing sequence of Fibonacci numbers to the current contents of said accumulator register means only in response to said second pulsed signal for each one bit in the input stream such that the Fibonacci numbers generated twice during the occurrence of the two pulses in said first pulse signal at each zero bit are not added to the accumulator register means, and output register means for receiving the accumulated contents of the accumulator register means each time the lowest Fibonacci number has been reached eventually to provide a decoded Fibonacci code sequence message.

The invention will now be described in connection with the accompanying drawings wherein;

Figs 1A and 1B are diagrammatic views of the Fibonacci code technique applied to optical sensing;

Figs 2A and 2B are block circuit diagrams of a suitable reader;

Fig 3 is a similar diagram of a logic-based debouncing circuit for use in Fig 2A;

Fig 4 is a chart illustrating the application of the variable code in the time card or similar system of Figs 1A and 1B;

Fig 5 is a block diagram illustrating the application of the invention to magnetic recording media such as tapes and disks;

Fig. 6 is a block circuit diagram and code chart for an examplary generator useful in Fibonacci code encoding and decoding for the purposes of the invention with different types of media;

Fig. 7 is a diagram of an encoder according to the invention, that encoder employing the generator of Fig. 6;

Fig. 8 presents waveforms illustrating the timing of the circuits of Fig. 7;

Fig. 9 is a block circuit diagram similar to Fig. 7 but of a decoder according to the invention;

Fig. 10 is a waveform diagram similar to Fig. 8, for the decoder circuit of Fig. 9.

Fig. 11 is a circuit diagram showing more detail of the generator of Fig. 6;

Fig. 12 is a table defining the contents of the PROMs of Figs. 6 and 11 in best mode application;

Fig. 13 is a detailed circuit of the subtractor component of the encoder of Fig. 7, and Figs. 14, 15 and 16 are similarly more detailed circuits of the multiplexer, accumulator register and "next word" register of Fig. 7, respectively;

Figs. 17 and 18 are similar detailed circuits of the respective adder and output register components of the decoder of Fig. 9;

Fig. 19 is a view similar to Fig. 5 illustrating the application of the invention to bar code printing as for the time cards of Figs. 1A, 1B and 4; and

Fig. 20 is a reproduction of a time card printed by the system of Fig. 19.

In the novel "Fibonacci Code" of the invention, a "1" is a single cell long, and a "0" is 2 cells long, with transitions separating the bits:

4

bits:

```
     | 0  |  0  | 1 | 1 | 0 | 1 | 0 | 0 |
      ___    _____    ___    _____    _
   __|   |__|       |__|   |__|       |__|
```

cells:

```
 | | | | | | | | | | | | | | | |
```

The raw code is thus variable length, depending on the data. At first blush, this would seem to make the code impossible for use on magnetic media and the like where typically the physical length of a block of a fixed number of bits must be the same, regardless of what the bits are (a block on a data tape, or a "sector" on a disc). Fortuitously, however, it turns out that the weighting of the raw code data by our Fibonacci Code makes such use totally possible.

Consider the number of different codes of a given length; i.e. a given number of cells, not a given number of bits. These codes can be enumerated recursively as follows:

To generate all codes of length n cells, where n is any integer:

Rule a.    Take all codes of length n-1, and add a "1" in front (since 1's are 1 cell long, this gives an n-cell code).

Rule b.    Take all codes of length n-2, and add a "0" in front (since 0's are 2 cells long, this gives an n-cell code)

Table II

All codes of length 1 cell:                          1

All codes of length 2 cells:                         11
(note Os drawn 2 cells wide)

All codes of length 3 cells:                         111
                                                     1

All codes of length 4 cells:                         1111
                                                     11
                                                     1  1
                                                     11
                                                     

All codes of length 5 cells:                         11111
                                                     111
                                                     11 1
                                                     1 11
                                                     1
                                                     111
                                                     1
                                                     1

All codes of length 6 cells:                         111111
                                                     1111
                                                     111
                                                     11 11
                                                     11
                                                     1 111
                                                     1 1      (codes above line
                                                     1 1      from rule (a);
                                                     1111     codes below line
                                                     11       from rule (b),
                                                     1 1      above
                                                     11
                                                     

Several results flow from this, as follows:

1. The number of codes of n cells in length is equal to the number of codes n-1 cells long plus the number of codes n-2 cells long. Further, there is one code of length 1 cell and two codes of length 2 cells. This is exactly the definition of the classic "Fibonacci numbers".

2. Since the numbers of codes "below the line" in Table II is always Fib (n-2), the code can be considered a weighted code (to convert to a binary equivalent); and the weight of the newly-added column on the left at level n is simply Fib(n-2).

This operation is detailed below:

Column #(n):        6   5   4   3   2   1
Column weight:          5   3   2   1   1   0 (column weight of right-most column is 0).
=Fib(n-2)

TABLE III

| Codes | Decimal Equivalent | |
|---|---|---|
| 1 1 1 1 1 1 | 12 | |
| 1 1 1 1 ⌒ | 11 | |
| 1 1 1 ⌒ 1 | 10 | Note: Add the weights of each column containing a "1" (obviously could add in binary just as easily). |
| 1 1 ⌒ 1 1 | 9 | |
| 1 1 ⌒ ⌒ | 8 | |
| 1 ⌒ 1 1 1 | 7 | |
| 1 ⌒ 1 ⌒ | 6 | |
| 1 ⌒ ⌒ 1 | 5 | |
| ⌒ 1 1 1 1 | 4 | |
| ⌒ 1 1 ⌒ | 3 | |
| ⌒ 1 ⌒ 1 | 2 | |
| ⌒ ⌒ 1 1 | 1 | |
| ⌒ ⌒ ⌒ | 0 | |

As an example, consider:

$$5 + 3 + 1 = 9$$

Weights:    5  3  2  1  1  0

Code:    1  1  ⌒  1  1

Since we have developed a weighted code (essentially a variable radix code), conversion routines to and from the code are obvious. The only unusual aspect is that zeros must be expanded to "double width" before applying the weights. This conversion algorithm allows the "Fibonacci Code" to be used as a fixed-length code.

For example, blocks of 16 bits can be coded into 24 cells (Fib(24) = 75,025; $2^{16}$ = 65,536); giving a code using only 1.5 cells per bit (2/3 bit/cell = 0.666... bits/cell). This code is a 33-1/3% improvement in packing density over phase encoding or Manchester encoding. Like those codes, there are at most two cells between transitions, and all transitions are exactly one cell or two cells apart.

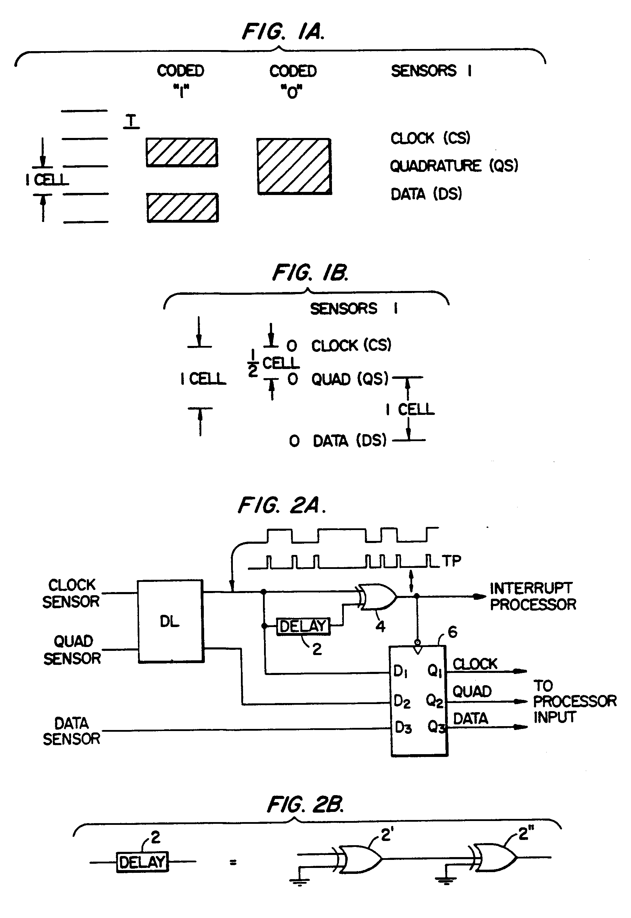

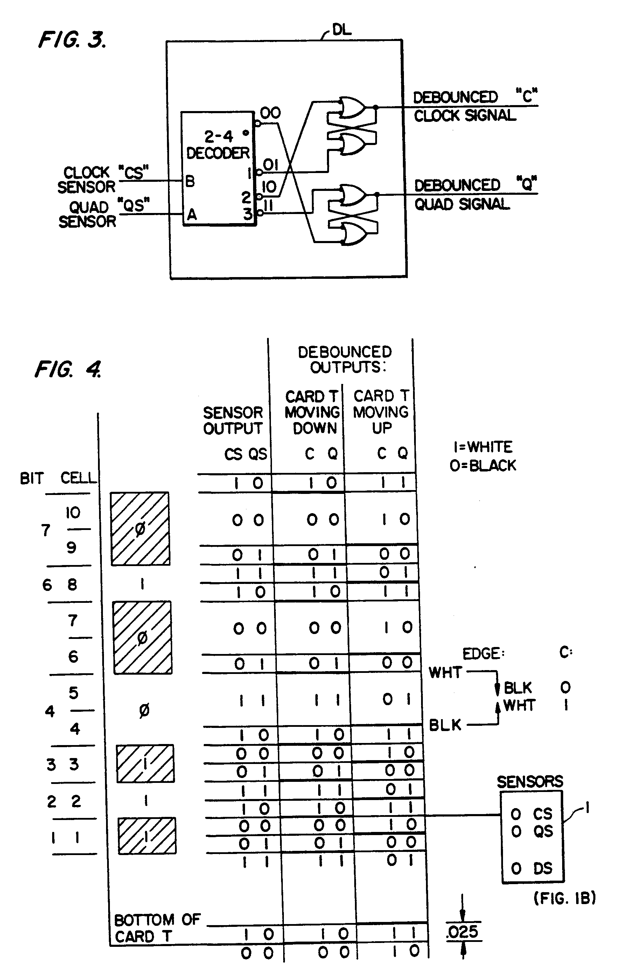

Considering an application of this technique to a moving time card, for example, containing bars recorded or stored thereon in accordance with the code of the invention for optical reading, a preferred scheme for reading this code optically from an irregularly moving time card, using a triple sensor, will now be described. Reference is made to Fig. 1A wherein exemplary bars for a coded "1" and coded "0" are shown on a timecard T in relation to three scanning optical sensors, labelled "clock" sensor CS (which detects the bar edge), "quadrature" sensor QS and "data" sensor DS, the spacings of which relative to a cell are more accurately portrayed in Fig. 1B. To read the code, the circuit of Figs. 2A and 2B may be employed wherein the debouncing logic circuit DL assumes the form of the circuit of Fig. 3, later described. The stage 6 of Fig. 2A may, for example, be of type 74176. Fig. 2B shows a suitable circuit form for the DELAY device 2 of Fig. 2A, the stages 2' and 2", for example, comprising successive type 7486 stages, such stage being suitable also at 4 for generating from the DL output, bi-directionally, the transition pulses (waveform TP). The DELAY 2 sets the pulse width of the transition pulses.

The computer or processor is interrupted on each edge of the clock. At interrupt, the direction of motion can be computed from the valve read in:

direction = clock + QUAD (where + is Exclusive - OR).

The data value used is

data bit = clock + data.

That is, if clock sensor output does not equal that of the data sensor, a 2-cell bar is read, which is "0". If, however, the clock and data sensor outputs are equal, a 1-cell bar, is read, which is "1". This operation holds for black or white bars. A lens (not shown) can be used to image the code onto the sensors. The use of the spacially placed multiple sensors of Fig. 2A makes the reading of the code totally independent of speed or even direction of motion of the code past the sensors.

As shown in Fig. 3, the debouncing logic circuit DL is applied to the output of each of the clock and quadrature sensors. With this debouncing, at least 1/2 cell reversal of the sensors over the code (or vice-versa) must occur before there is another change in the outputs. This prevents jitter around an edge from interrupting at too rapid a rate, without introducing any delay in the response to a true valid edge. The DECODER of DL may, for example, be one-half of a type 74139, with the gates of type 7400, producing the debounced "C" and "Q" signal outputs illustrated.

The variable code application of the Fibonacci Code to the time card or similar useage of Figs. 1-3 is illustratively summarized in the chart of Fig. 4, showing the sensor 1 of Fig. 1B with its "CS" and "QS" outputs and the corresponding debounced outputs "C" and "Q" for the card T moving down and up, respectively. The debounced "C" output is used to produce interrupts and is defined as the state after interrupt, as diagrammatically shown to the right in Fig. 4.

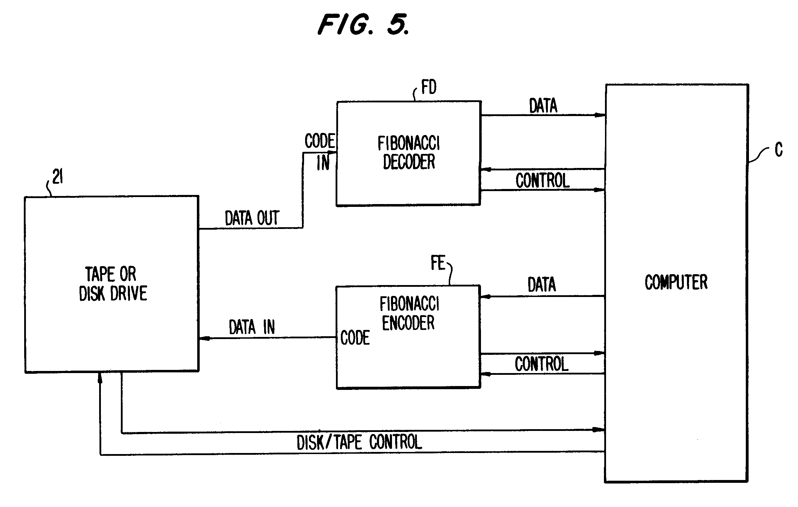

Preferred or best mode embodiments of a suitable Fibonacci encoder and decoder systems for the purposes of the present invention will now be described. The example chosen would, for example, be used for encoding in conventional fashion 16 bit words for recording or storage on a magnetic tape or disk in Fibonacci Code, or to control a conventional computer driven ink printer (as later described) to record the before-mentioned bars on the time card T or other medium of Figs. 1A and 4. For the former application, as an illustration, it will be assumed that these words are being fed to the interface by a computer for recording on the tape in such code and that words read back from the tape in that Fibonacci Code will be converted back to 16 bit words to be read by a computer. In the top-level block diagram shown in Fig. 5, the encoder FE inputs data (DATA IN) to the tape or disk drive 21, the output data from which (DATA OUT) is applied to the decoder FD, with the computer C applying disk/tape control, as indicated, input data to the encoder FE and control signal communication with "FE and decoder FD".

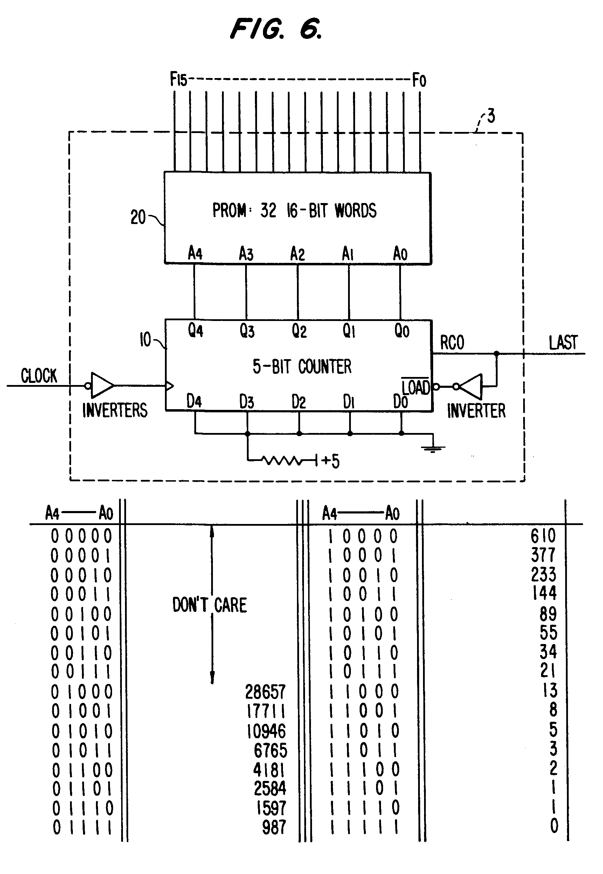

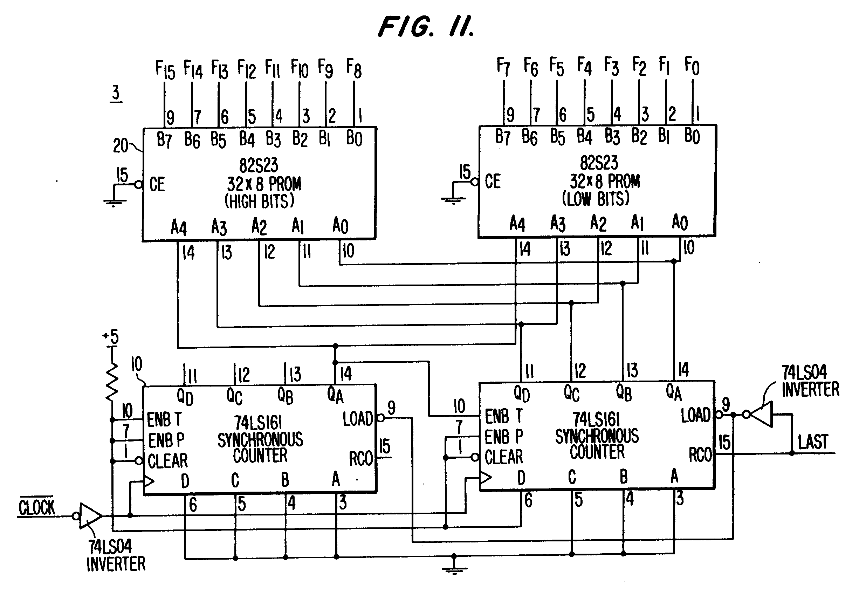

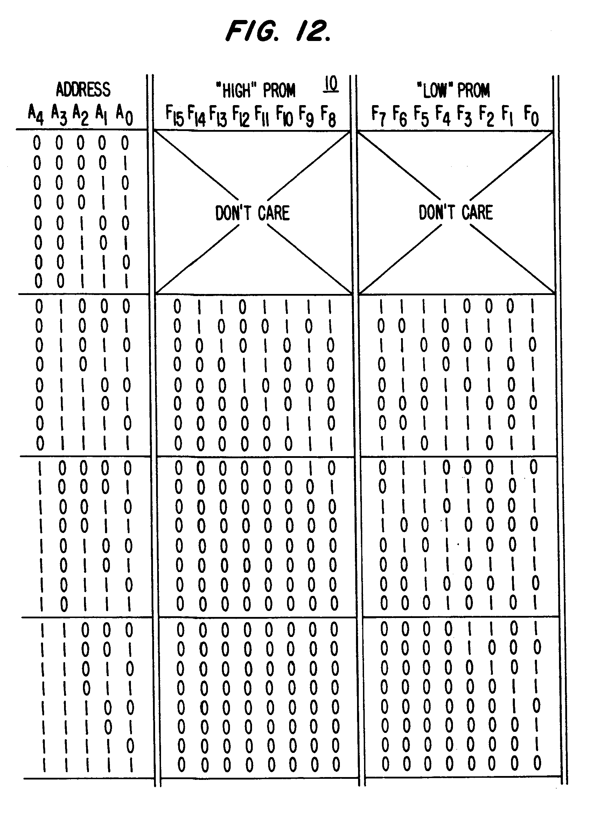

A common circuit that may be used in both the Fibonacci encoder FE and the decoder FD is a Fibonacci generator, shown at 3 in Fig. 6. Although a Fibonacci generator could clearly be made up out of adders and registers, calculating a new Fibonacci number each time it is pulsed by the clock input, it is simpler to just use a counter 10 driving a Programmable Read Only Memory (PROM) 20. In this example, 24 Fibonacci numbers are required, as shown in the table at the bottom of Fig. 6. The numbers encoded into the PROM 20 are shown in decimal, although of course in actuality they would be converted to binary, as is more evident from later-described Figs. 11 and 12. Since only 24 of the 32 words in the PROM are used, the counter 10 is pre-loaded with the value of 8. At the trailing edge of each clock pulse, the Fibonacci generator 3 will produce the next Fibonacci number, starting with the higher numbers in the series and working down. It will be seen that the encoder FE and decoder FD produce and read a serial code which has the most significant bit of the Fibonacci Code first.

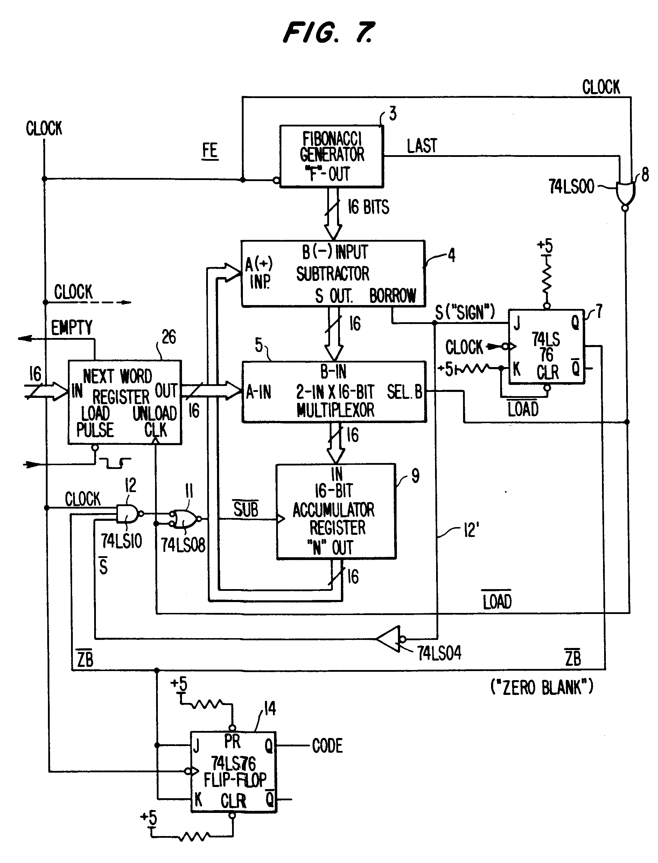

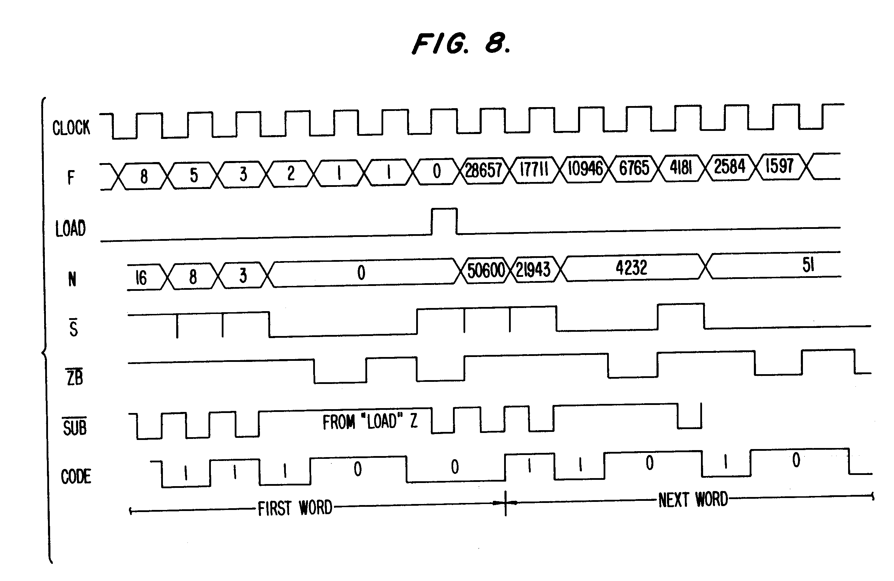

In the illustrative Fibonacci encoder circuit FE of Fig. 7, the waveforms of the timing diagram of Fig. 8 apply. The "CLOCK" signal (first waveform of Fig. 8) pulses once for the start of each possible short cell on the tape or disk, its frequency being determined by dividing the desired tape recording density, in flux-changes-per-inch (fcpi), by the tape speed, in inches-per-second (ips). At the end of every 24 cells, the Fibonacci generator 3 will produce the signal LAST, Fig. 6, which will cause the word held in the next word register 26 of Fig. 7 to be transferred to the 16-bit accumulator register 9. This word is the next word which is to be written onto the tape. This is done by producing the LOAD pulse (Fig. 8) out of gate 8, which switches a multiplexer 5 to read the next word register 26, and also pulses accumulator register 9 via gate 11. On the following clock pulse, the Fibonacci generator 3 will begin counting down from the high Fibonacci numbers, producing these outputs at its F-OUT lines, which feed the negative input to the subtractor circuit. In Fig. 8, there is shown the end of one 16-bit word, a load from the next word register 26, and the beginning of the next 16-bit word. At each clock cycle, the subtractor 24 subtracts the current Fibonacci number from the current contents of the accumulator register 9. The subtractor 24 is also acting as a comparator, since it will produce a borrow signal only if the Fibonacci number is greater than the current contents of the accumulator register 9. If the number in the accumulator register 9 is larger than the current Fibonacci number, the clock pulse will pass through gates 12 and 11, and clock the accumulator register 9, causing the current Fibonacci number to be subtracted from the current number in the accumulator register 9. If, however, the current Fibonacci number is too large to be subtracted, the borrow signal S, fed via 12' into gate 12, will prevent accumulator register 9 from being clocked; and that Fibonacci number will not be subtracted on that cycle. The signal S, furthermore, will set flip-flop 7, producing the signal ZB ("ZERO BLANK"), Figs. 7 and 8. This signal, fed into gate 12, will also prevent the following clock from pulsing accumulator register 9. Thus, two clock pulses will be skipped without performing a subtraction from accumulator register 9, thus producing zeroes in the output code which are two cells long. The ZB signal will always then be removed on the following clock cycle due to the way the JK inputs are connected, regardless of the state of signal S. The final output code, to be written directly on the tape, is produced by flip-flop 14, which is complemented by every single clock pulse, except if the signal ZB is asserted. The final output signal CODE, Figs. 7 and 8, can be written directly onto a saturating magnetic tape.

By the above operation, the encoder circuit FE produces the Fibonacci Code using the method previously described. It attempts to subtract the highest weight still remaining, and if it can do so it subtracts that weight. But if it cannot do so, it performs the additional step of skipping over the next lowest Fibonacci weight, in order to allow for the double width zeroes. This is related to the conventional radix conversion type circuit, in the sense that if the weights used were the BCD weights (1, 2, 4, 8, 10, 20, 40, 80,...) instead of the Fibonacci numbers, and if the subtraction following the occurrence of a zero were not omitted, a standard binary to BCD ("Binary-Coded-Decimal") conversion would result, as is well known.

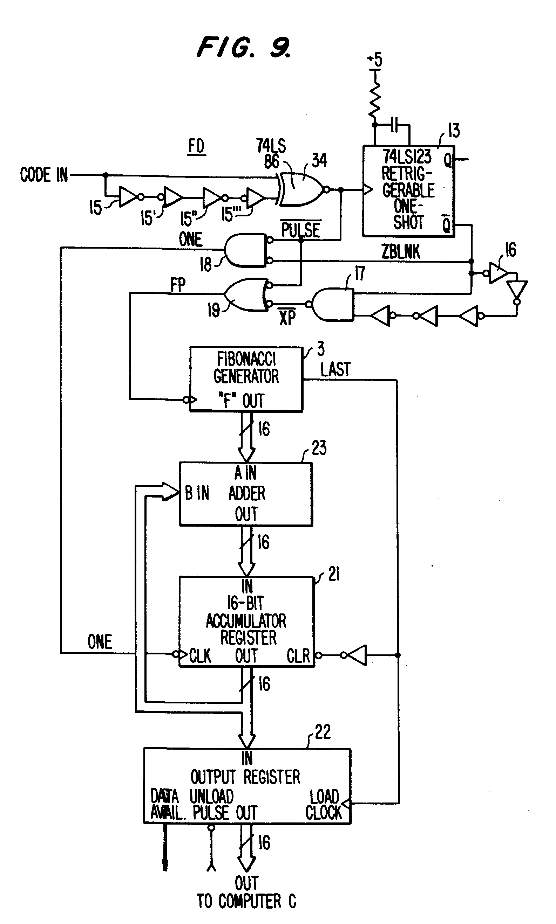

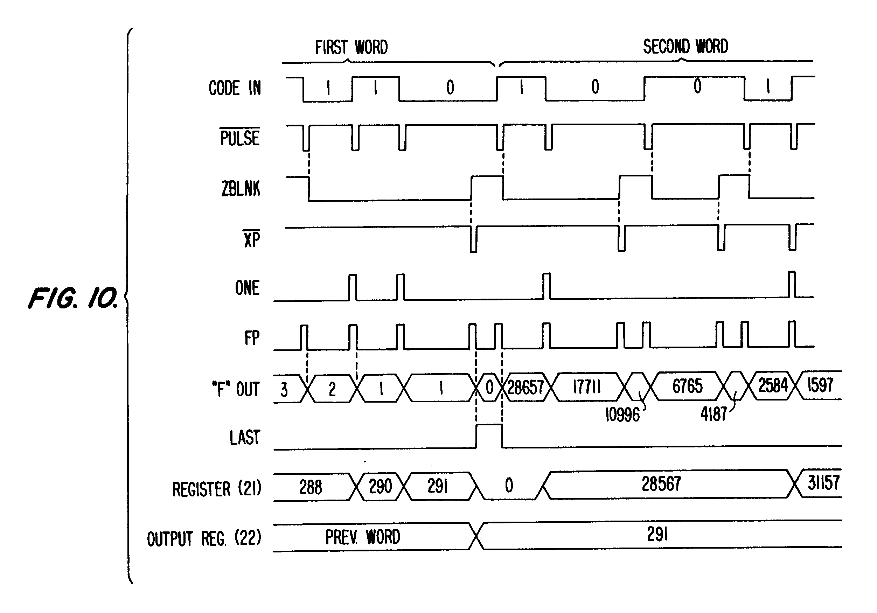

Turning, now, to the Fibonacci decoder FD shown in Fig. 9, the waveforms descriptive of its operation are shown in the timing diagram of Fig. 10. Again, the end of one word and the beginning of a second word are shown, although the same words are not used as in the first example. As is typical in a Manchester or other such decoder, the signal is fed into an exclusive-OR-gate 34, once directly, and once through a delay circuit 15-15'''. The resulting output PULSE (Figs. 9 and 10) has a short pulse for every transition in the CODE IN signal. This is fed into a retriggerable one-shot 13 with the duration of about one and a half cell times. The job of this one-shot is to distinguish between single and double cells in the input stream. In a medium with excellent speed control, the period of the one-shot could be fixed. It is commonplace, however, to sue a feedback circuit to adjust the period of the one-shot for the observed speed variations in the tape. A pulse will be taken as being the trailing edge of a "1" bit (two cells long) if the one-shot has not yet timed out when that pulse arrives. This is done by AND-gate 18, Fig. 9, producing a pulse only at the conclusion of "1" bits. This pulse is appropriately called ONE, Figs. 9 and 10. The signal PULSE is a pulse which occurs at the conclusion of all Fibonacci Code bits, whether "1" or "0". However, zeroes ("0") are actually two cells long, and an additional pulse is needed for each of the double cell zeroes. This is generated by feeding the output ZBLNK (Figs. 9 and 10) of the one-shot 13 through a circuit which will produce a pulse at the trailing edge of the one-shot output. This circuit, comprising delay chain 16 and the AND-gate 17 of Fig. 9, produces the pulse XP at the trailing edge only of ZBLNK. By combining this with PULSE in gate 19, a signal FP for pulsing the Fibonacci generator 3 is produced which contains a single pulse at the conclusion of each one bit, as shown in Fig. 10, and two pulses during a zero bit, which is two cells long.

The manner in which the decoder FD operates is as follows. As before, the Fibonacci generator 3 generates the Fibonacci words in sequence, starting from the highest and working down. The 16-bit accumulator register 21 is initially cleared, and the Fibonacci number is added in the adder 23 to accumulator register 21 for each "1" bit in the input stream. Whenever there is a "0" bit in the input stream (two cells long), the pulse ONE is omitted, so the register 21 is not pulsed, and in effect the Fibonacci number for that cell is not added in the adder 23. In addition, the Fibonacci generator 3 is pulsed twice by the pulse FP during that bit; once by the pulse XP when the one-shot 13 times out, and a second time by the pulse PULSE at the conclusion of the bit. Thus, not one, but two Fibonacci numbers are skipped over for each zero bit. When the last Fibonacci number has been reached, the signal LAST, Fig. 10, is asserted for one cell, transfering the completed output into the output register 22, and clearing the accumulator register 21. It should be observed that if there is a one in the last cell of the code, this clearing operation will interfere with the addition of the Fibonacci number that would normally be done on that cycle. However, the lowest Fibonacci number for the last cell is a zero anyway, so in fact that number in the accumulator register 21 is already complete by the beginning of the final cell. The final cell in a Fibonacci Code is essentially a place holder, of zero value, except that it allows the number of ones in all of the previous cells to be either odd or even, while still retaining the fixed length characteristics of the code.

Again, this bears similarity to a standard radix conversion circuit; that is, if the numbers out of the Fibonacci generator were chosen differently, and a number were not skipped on the occurrence of a "0" bit, this circuit could be used to do a standard Binary Coded Decimal (BCD) to binary conversion in conventional fashion. By choosing the Fibonacci weights, and by accounting for the double width zero bits, a Fibonacci decoder FD is generated, instead.

The starting up of the encoder circuit FE and the synchronizing of the decoder circuit FD as required in an actual magnetic tape interface, may be approached in the following manner. The encoder may be started by outputting the word having value "one". This would produce a fixed preamble of zero cells, which would allow the period of the retriggerable one-shot 13, Fig. 9, to be adjusted slightly to match the actual tape speed during the preamble. This word would produce a Fibionacci Code which would terminate with two one-cells, which could be detected to start up the decoder circuit. A suitable magnetic tape cassette transport apparatus useable with the above-described decoder FD and encoder FE is, for example, the Type CM 600 Mini Cassette Transport of Braemar Computer Devices, Inc. of Burnsville, Minnesota.

Considering, now, illustrative practical circuit components useful to implement the encoder and decoder circuits, reference may be made to Fig. 11 which provides further details of the Fibonacci generator 3, of Fig. 5, common to both the encoder FE and decoder FD of Figs. 7 and 9, respectively. In the specific implementation of Fig. 11, standard bipolar integrated circuits are shown, with the high bit and low bit PROMS 20 being, for example, of the Segnetics Type 82S23 PROM (32 by 8); and the corresponding synchronous counters 10 may be of the Texas Instruments Type SN74LS161. The "INVERTER" used in the CLOCK input to and in the output of the counter 10 (Figs. 5 and 11) may be of the hex Type SN74LS04 of Texas Instruments. The PROM contents for the high and low PROMS 20 of Fig. 11 are set forth in Fig. 12, being more detailed than those shown for address $A_o$-$A_4$ at the bottom of the more general diagram of Fig. 5. The addresses $A_o$-$A_4$ of each of the low and high bit PROMS 20 are tabulated in the left-most column of Fig. 12, and the PROM lines $F_o$-$F_7$ and $F_8$-$F_{15}$ are tabulated in the right-most and center columns, respectively, for a best mode embodiment.

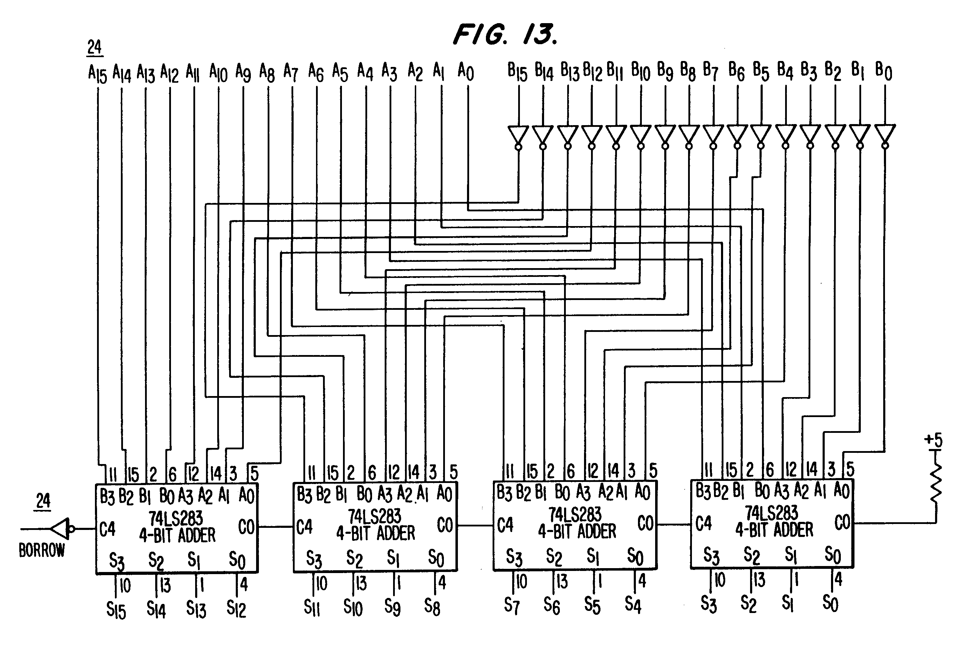

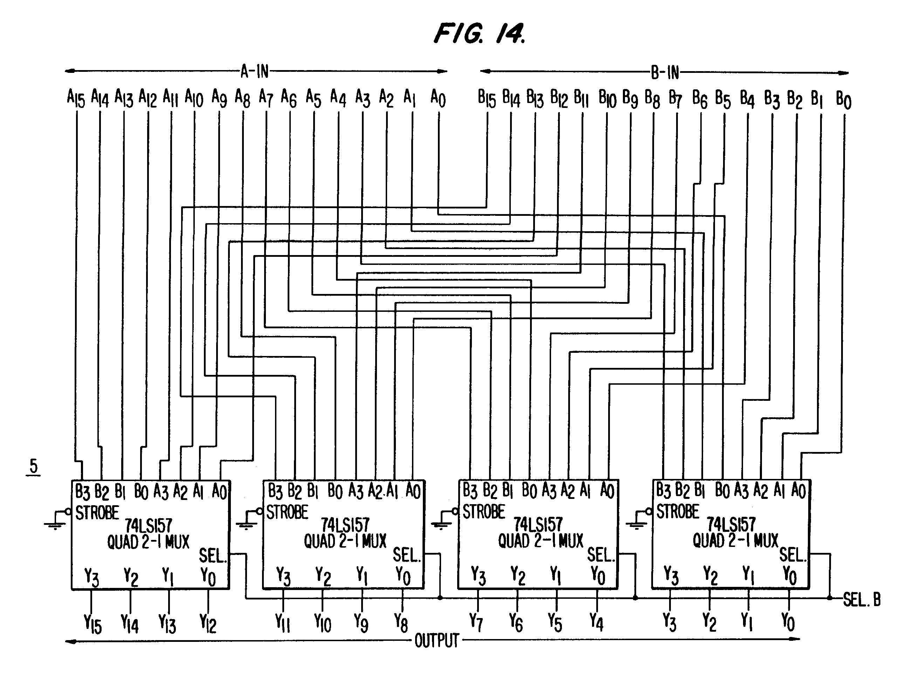

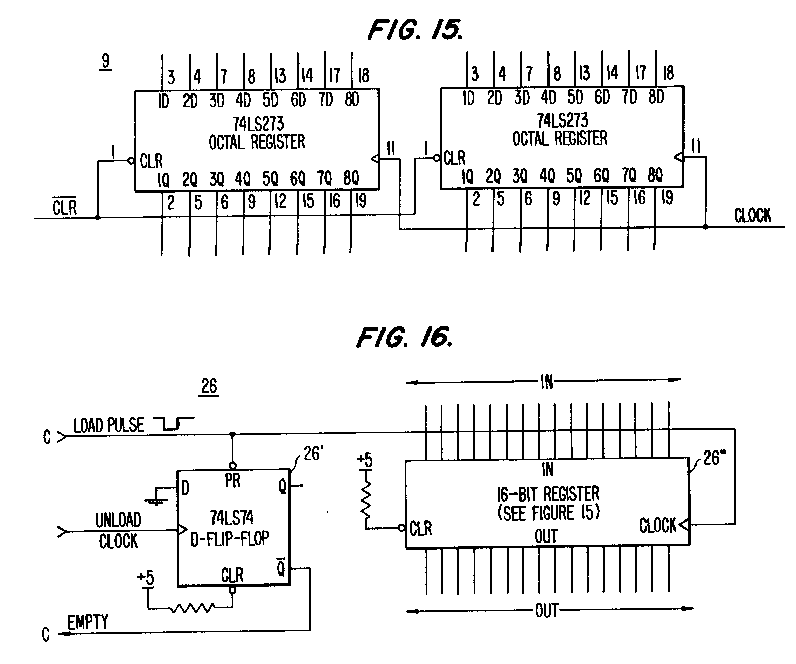

A preferred format for the subtractor 24 of the Fibonacci Encoder FE of Fig. 7 is detailed in Fig. 13 with respective 16-bit inputs $A_o$-$A_{15}$ and $B_o$-$B_{15}$ applied to four 4-bit address illustrated as of the Texas Instruments Type SN74LS283, producing the 16 outputs $S_o$-$S_{15}$ for application to the multiplexer 5 (Fig. 7). A twos-complement subtraction is caused by inverting the B input lines, and adding one via the lowest carry-in input CO. Of course, if the Fibonacci generator is not shared with the one used in the decoder, the Fibonacci numbers in the generator PROM could be inverted, and the inverters could then be eliminated. Such a multiplexer 5 is more specifically detailed in Fig. 14, with its 16 A and B inputs ($A_o$-$A_{15}$ and $B_o$-$B_{15}$) applied to four quad 2-1 multiplexer chips of the Texas Instruments Type SN74LS157, for example, providing outputs 1/o-1/15 for application to the 16-bit accumulator register 9 of Fig. 7. That register 9 may assume the specific form of Fig. 15, comprising a pair of octal registers as of the Texas Instruments Type SN74LS273.

Continuing with the encoder of Fig. 7, the "next word" input register 26, may be of the configuration shown in Fig. 16 providing "handshaking" logic, later amplified. The register is shown in the format of a flip-flop 26′ (as of the Texas Instruments Type Dual-D SN74LS74) and a 16-bit register 26″ (as of the type shown in Fig. 15). The "LOAD PULSE" (Figs. 16 and 7) sets the flip-flop 26′ removing the "EMPTY" signal. The trailing edge clocks the register 26″ with data from the computer C on the input lines. The "UNLOAD CLOCK" occurs when the word in the register has been used. It clears the flip-flop on its trailing edge, asserting the "EMPTY" signal, which informs the computer C that it can send another word. This handshaking flip-flop provides synchronization between the computer, which loads the input register, and the encoder circuit, which unloads it.

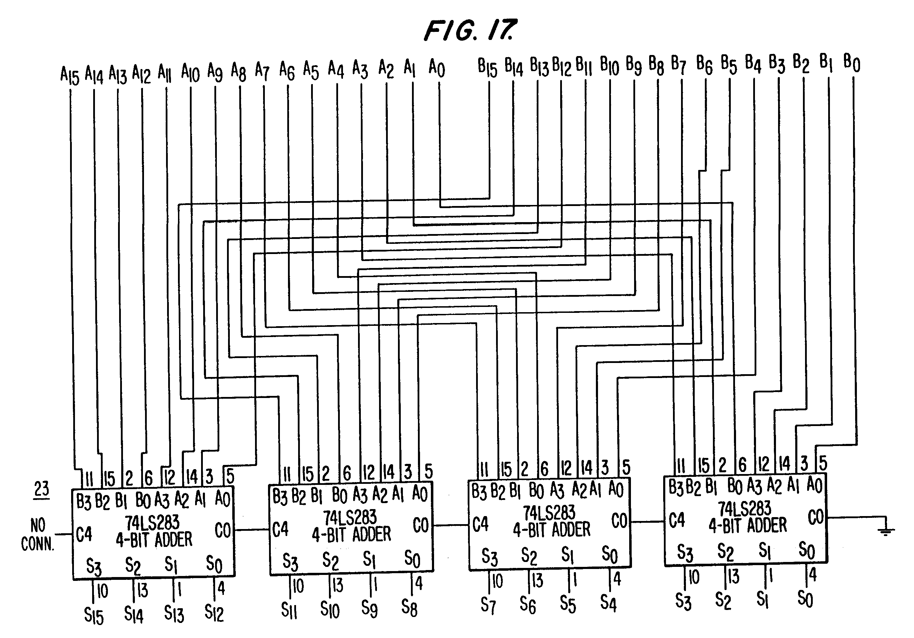

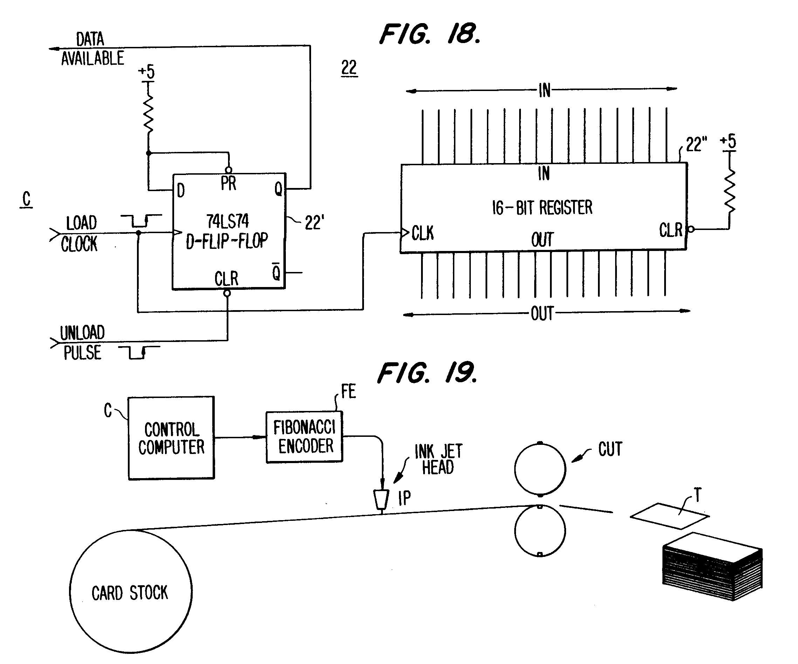

Fig. 17 details a preferred form of adder 23 for the decoder FD of Fig. 9 embodying four 4-bit adders, as of the Texas Instruments Type 74LS283, also used in the substractor 24 of Figs. 7 and 13. The decoder output register 22 of Fig. 9 may assume the form of Fig. 18 (somewhat similar to that of Fig. 16), using a D flip-flop 22′ and 16 bit register 22″, as of the types before listed. The "LOAD CLOCK" input clocks data from the Fibonacci decoder "IN" to the register and sets the flip-flop, asserting the "DATA AVAILABLE" signal to the computer C. The computer reads the data onto its bus using the "UNLOAD PULSE", which also clears the flip-flop and removes the "DATA AVAILABLE" signal--again, a "handshaking" logic operation with the computer C.

Suitable chips for other components may be as follows: retriggerable one-shot 13 of the decoder of Fig. 9--Texas Instruments Types 74LS123; and in the encoder of Fig. 7, triple 3-input NAND gate 12--Type SN74LS10; quad 2-input AND gate 11--Type SN74LS08; dual J-K Flip Flops 7 and 14--SN74LS76; and quad 2-input NAND gate 8--SN74LS00.

Returning to the use of the invention on time cards T, as described in connection with Figs. 1A-4, the encoder FE and decoder FC may equally well be used to interface with printing apparatus to record/or store bar codes on cards or other media (Figs. 1 and 4) instead of on magnetic media as above. When optically reading a bar code, as by the sensors 1 of Figs 1A and 1B, it is possible to image the code with a lens onto multiple sensors 1, which eliminates the issue of speed control which exists with magnetic media. Multiple magnetic read heads may also solve the speed problem on magnetic media, but can be impractical due to the small head spacing that would be required (the head spacing would be smaller than the actual heads themselves).

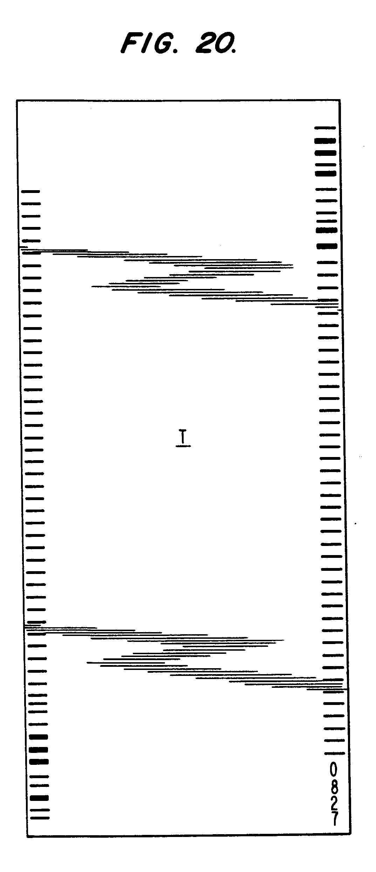

As for printing the code bars on the time card T, fixed codes can be printed in a conventional manner. Variable or sequenced codes can easily be printed by feeding the output of the encoder circuit FE above-described to an ink-jet press IP, Figs 19. In this case, tuning the ink stream on and off is the equivalent of driving a tape head in the magnetic case. A typical time-card printed by this process is shown in Fig 20, in part Fibonacci-encoded, with the encoder FE driving a model 2700 Diconix Ink-Jet Printer.

## Claims

1. Data encoding apparatus comprising clocking means for providing clocking pulses at predetermined frequencies, computer controlled next-word register means (26) for storing bit words to be encoded, accumulator register means (9) for receiving a word to be encoded from the next-word register means (26), multiplexor means (5) for transferring a bit word held in the next-word register means (26) to said accumulator register means (9) in response to a clocking pulse applied thereto at the end of a previously encoded word, Fibonacci number generator means (3) for generating sequentially lowering Fibonacci numbers from a pre-set highest Fibonacci number in response to a clocking pulse of said clocking means, subtractor means (4) for comparing the current Fibonacci number with the current contents of the accumulator register means (9) at each clock cycle so that if the current contents of the accumulator register means (9) is higher than the current Fibonacci number, the accumulator register means (9) is clocked by said clocking means through first and second gate means (12, 11) so that the current Fibonacci number is subtracted from the current contents of the accumulator register means (9) and an associated first flip-flop (14) is clocked by said clocking means to produce a coded one that is one cell long in Fibonacci code sequence, said subtractor means providing a first output inhibitor signal via said first gate means (12) to prevent the accumulator register being clocked by a subsequent clock pulse if the current number in the accumulator register means is smaller than the current Fibonacci number and to set a second flip-flop (7) causing same to send a second inhibitor signal via said first gate means (12) to prevent the accumulator register being clocked on the following clock pulse and such that said first flip-flop (14) is clocked by said clocking means to produce coded zeros that are two cells long in Fibonacci code sequence.

2. Data decoding apparatus comprising circuit means (15, 15', 15″, 34, 13, 16-19) for receiving a message encoded in Fibonacci code sequence wherein received zero bits are two cells long and one bits are one cell long and generating in response thereto a first pulsed signal (FP) containing a single pulse for each one bit received and two pulses during a zero bit, and a second pulsed signal (ONE) containing a single pulse at the conclusion of each one bit in the input stream, Fibonacci number generator means (3) operable in response to the first pulsed signal (FP) to generate sequentially decreasing Fibonacci numbers from a preset highest number to a preset lowest number, accumulator register means (21) operable in conjunction with adder means (23) for adding a Fibonacci number in the decreasing sequence of Fibonacci numbers to the current contents of said accumulator register means (21) only in response to said second pulsed signal (ONE) for each one bit in the input stream such that the Fibonacci numbers generated twice during the occurrence of the two pulses in said first pulse signal (FP) at each zero bit are not added to the accumulator register means (21), and output register means (22) for receiving the accumulated contents of the accumulator register means each time the lowest Fibonacci number has been reached eventually to provide a decoded Fibonacci code sequence message.

## Patentansprüche

1. Vorrichtung zum Codieren von Daten, mit Taktgebermitteln zur Erzeugung von Taktimpulsen mit vorgegebenen Frequenzen, mit Computer gesteuerten Nächstes-Wort- oder Folge-Wort-Speicher-oder Registermitteln (26) zur Speicherung von zu codierenden Bit-Wörtern, Akkumulator-Registermitteln (9) zur Aufnahme eines zu codierenden Wortes aus dem Folge-Wort-Registermitteln (26), Multiplexor-Mittel (5) zur Übertragung eines Bit-Wortes, welches in den Folge-Wort-Registermitteln gehalten ist, an die erwähnten Akkumulatorregistermittel (9) in Abhängigkeit von einem Taktimpuls am Ende eines zuvor codierten Wortes, Fibonacci-Zahl-Generatormittel (3) zur Erzeugung von Fibonacci-Zahlen, die in Abhängigkeit von einem Taktimpuls der Taktgebermittel von einer vorgegebenen hächsten Fibonacci-Zahl sequenziell abnehmen, Subtrahier-oder Subtraktormittel (4) zum Vergleichen der laufenden bzw. aktuellen Fibonacci-Zahl mit dem laufenden bzw. aktuellen Inhalt der Akkumulatorregistermittel (9) an jedem Taktzyklus, wobei dann, wenn der jeweilige oder aktuelle Inhalt der Akkumulatorregistermittel (9) höher ist als die jeweilige oder aktuelle Fibonacci-Zahl, die Akkumulatorregistermittel (9) durch die Taktgebermittel über erste und zweite Gattermittel (12, 11) getaktet werden, so daß die tatsächliche Fibonacci-Zahl von dem tatsächlichen Inhalt der Akkumulatorregistermittel (9) abgezogen und ein zugeordnetes erstes Flip-Flop (14) durch die erwähnten Taktgebermittel getaktet wird, um eine codierte Eins zu erzeugen, die der Länge eines Platzes in der Fibonacci-Code-Sequenz entspricht, wobei die Substraktor-Mittel ein erstes sperrendes Ausgangssignal oder Inhibitor-Ausgangssignal über die ersten Gattermittel liefern, um ein Takten des Akkumulatorregisters durch einen nachfolgenden Taktimpuls zu verhindern, wenn die aktuelle Zahl in den Akkumulatorregistermitteln kleiner ist als die aktuelle Fibonacci-Zahl, und um ein zweites Flip-Flop (7) zu setzen und zu veranlassen, ein zweites Inhibitor-Signal über die ersten Gattermittel (12) zu senden, um ein Takten des Akkumulatorregister am folgenden Taktimpuls zu verhindern, so daß das erste Flip-Flop (14) durch die Taktgebermittel getaktet wird, um codierte Nullen zu erzeugen, die in der Fibonacci-Code-Sequenz einer Länge von zwei Plätzen entsprechen.

2. Vorrichtung zum Decodieren von Daten, mit Schaltkreismitteln (15, 15', 15″, 34, 13, 16-19) zum Empfang einer Nachricht, die in einer Fibonacci-Code-Frequenz codiert ist, bei der empfangene Null-Bit der Länge zweier Plätze und empfangene Eins-Bit der Länge eines Platzes entsprechen, sowie in Abhängigkeit hiervon zur Erzeugung erstes impulsförmiges Signal (FP), welches jeweils einen einzelnen Impuls für jeden empfangenen Eins-Bit und zwei Impulse während eines Null-Bit aufweist, und eines zweiten Impulssignal (ONE), welches einen einzelnen Impuls am Ende jedes Eins-Bit in der Eingangsfolge aufweist, mit Fibonacci-Zahlen-Generatormittel (3), die in Abhängigkeit vom ersten impulsförmigen Signal (FP) betätigt werden, um Fibonacci-Zahlen zu erzeugen, die sequenziell von einer vorgegebenen höchsten Zahl auf eine vorgegebene niedrigste Zahl abnehmen, mit Akkumulatorregistermittel (21), die mit Addiermitteln (23) zusammenwirken, und zwar für eine Addition einer Fibonacci-Zahl in der abnehmenden Sequenz der Fibonacci-Zahlen und des laufenden bzw. tatsächlichen Inhalts der erwähnten Akkumulatorregistermittel (21), und zwar lediglich in Abhängigkeit von dem erwähnten zweiten Impulssignal (ONE) für jeden Eins-Bit in der Eingangsfolge derart, daß die Fibonacci-Zahlen, die beim Auftreten der beiden Impulse im ersten Impulssignal (FP) bei jedem Null-Bit erzeugt werden, nicht zu den Akkumulator-Registermitteln (21) addiert werden, sowie mit Ausgangsregistermitteln (22) zum Aufnehmen des akkumulierten Inhalts der Akkumulatorregistermittel immer dann, wenn die unterste Fibonacci-Zahl erreicht ist, um eventuell eine decodierte Fibonacci-Code-Nachricht zu liefern.

## Revendications

1. Appareil de codage des données comprenant un moyen d'horloge pour délivrer des impulsions d'horloge sur des fréquences prédéterminées, un moyen (26) de registre du mot suivant, commandé par ordinateur pour mémoriser des mots en bits à coder, un moyen (9) de registre accumulateur pour recevoir un mot à coder venant du moyen (26) de registre du mot suivant, un moyen de multiplexage (5) pour transférer un mot en bits, gardé dans le moyen (26) de registre du mot suivant vers ledit moyen (9) de registre accumulateur, en réponse à une impulsion d'horloge qui lui est appliquée à la fin d'un mot précédemment codé, un moyen (3) de générateur de nombres de Fibonacci pour former des nombres séquentiellement décroissants depuis un plus grand nombre de Fibonacci prédéfini, en réponse à une impulsion d'horloge venant dudit moyen d'horloge, un moyen de soustraction (4) destiné à comparer le nombre actuel de Fibonacci avec le contenu actuel du moyen (9) de registre accumulateur à chaque cycle d'horloge, de façon que si le contenu actuel du moyen (9) de registre accumulateur est supérieur au nombre actuel de Fibonacci, le moyen de registre accumulateur (9) soit synchronisé par ledit moyen d'horloge, grâce à un premier et second moyens de porte (12, 11) afin que le nombre de Fibonacci actuel soit retranché du contenu actuel du moyen (9) de registre accumulateur et qu'une première bascule (14) associée soit synchronisée par ledit moyen d'horloge pour former un "un" codé ayant la longueur d'une cellule de la séquence de code de Fibonacci, ledit moyen de soustraction formant un premier signal inhibiteur de sortie par l'intermédiaire dudit premier (12) moyen de porte, afin d'empêcher le registre accumulateur d'être synchronisé par une impulsion d'horloge suivante, si le nombre actuel contenu dans le moyen de registre accumulateur est inférieur au nombre de Fibonacci actuel, et de positionner une seconde bascule (7) en la sollicitant pour qu'elle envoie un second signal inhibiteur, par l'intermédiaire dudit moyen de porte (12), qui empêche le registre accumulateur d'être synchronisé sur l'impulsion d'horloge suivante, et soit tel, que ledit premier moyen de bascule (14) soit synchronisé par ledit premier moyen d'horloge afin de former des "zéros" codés ayant une longueur de deux cellules, dans la séquence du code de Fibonacci.

2. Appareil de décodage de données comprenant des moyens de circuits (15, 15', 15″, 34, 13, 16-19) pour recevoir un message codé en séquence de code Fibonacci dans lequel les bits zéros reçus ont une longueur de deux cellules et les bits "uns" une longueur d'une cellule, et pour former, en réponse, un premier signal pulsé (FP) comprenant une seule impulsion pour chaque bit "un" reçu et deux impulsions pendant un bit "zéro", et un second signal pulsé [ONE (UN)] contenant une seule impulsion à la fin de chaque bit "un" du flux d'entrée, un moyen (3) générateur de nombres de Fibonacci pouvant agir en réponse au premier signal pulsé (FP) pour créer des nombres de Fibonacci séquentiellement décroissants depuis un plus grand nombre prédéfini jusqu'à un plus petit nombre prédéfini, un moyen (21) de registre accumulateur utilisable en liaison avec un moyen d'addition (23) pour ajouter un nombre de Fibonacci de la séquence décroissante des nombres de Fibonacci au contenu actuel dudit moyen de registre accumulateur (21) uniquement en réponse audit second signal (ONE) pour chaque bit "un" du flux d'entrée, de manière que les nombres de Fibonacci formés deux fois pendant l'apparition de deux impulsions dudit premier signal pulsé (FP) à chaque bit "zéro" ne soient pas ajoutés au moyen (21) de registre accumulateur et au moyen de registre de sortie (22) pour recevoir le contenu accumulé du moyen de registre accumulateur à chaque fois que le nombre de Fibonacci le plus petit a été atteint éventuellement pour former un message décodé en séquences de code Fibonacci.

## FIG. IA.

CODED "I"

CODED "O"

SENSORS I

CLOCK (CS)

QUADRATURE (QS)

DATA (DS)

I CELL

I

## FIG. IB.

SENSORS I

I CELL

$\frac{1}{2}$ CELL

O CLOCK (CS)

O QUAD (QS)

I CELL

O DATA (DS)

## FIG. 2A.

CLOCK SENSOR

QUAD SENSOR

DATA SENSOR

DL

DELAY 2

TP

4

6

INTERRUPT PROCESSOR

$D_1$ $Q_1$ CLOCK

$D_2$ $Q_2$ QUAD

$D_3$ $Q_3$ DATA

TO PROCESSOR INPUT

## FIG. 2B.

2 DELAY = 2' 2"

**FIG. 3.**

CLOCK "CS" SENSOR → B

QUAD "QS" SENSOR → A

2-4 DECODER

DEBOUNCED "C" CLOCK SIGNAL

DEBOUNCED "Q" QUAD SIGNAL

**FIG. 4.**

| BIT | CELL | | SENSOR OUTPUT | | DEBOUNCED OUTPUTS: | | | |
|---|---|---|---|---|---|---|---|---|
| | | | | | CARD T MOVING DOWN | | CARD T MOVING UP | |
| | | | CS | QS | C | Q | C | Q |
| | | | I | O | I | O | I | I |
| 7 | 10 / 9 | ∅ | O | O | O | O | I | O |
| | | | O | I | O | I | O | O |
| 6 | 8 | I | I | I | I | I | O | I |
| | | | I | O | I | O | I | I |
| | 7 / 6 | ∅ | O | O | O | O | I | O |
| | | | O | I | O | I | O | O |
| 4 | 5 / 4 | ∅ | I | I | I | I | O | I |
| | | | I | O | I | O | I | I |
| 3 | 3 | I | O | O | O | O | I | O |
| | | | O | I | O | I | O | O |
| 2 | 2 | I | I | I | I | I | O | I |
| | | | I | O | I | O | I | I |
| I | I | I | O | O | O | O | I | O |
| | | | O | I | O | I | O | O |
| | | | I | I | I | I | O | I |
| BOTTOM OF CARD T | | | I | O | I | O | I | I |
| | | | O | O | O | O | I | O |

I = WHITE
O = BLACK

EDGE:          C:
WHT → BLK    O
BLK → WHT    I

SENSORS
O  CS — I
O  QS
O  DS

(FIG. IB)

.025

# FIG. 5.

## FIG. 6.

F15 - - - - - - - - - - - - - - - F0

3

PROM: 32 16-BIT WORDS

20

A4    A3    A2    A1    A0

Q4    Q3    Q2    Q1    Q0    RCO    LAST

10

5-BIT COUNTER

CLOCK

INVERTERS

D4    D3    D2    D1    D0    LOAD    INVERTER

+5

| A4 —— A0 | | | A4 —— A0 | |
|---|---|---|---|
| 0 0 0 0 0 | | 1 0 0 0 0 | 610 |
| 0 0 0 0 1 | | 1 0 0 0 1 | 377 |
| 0 0 0 1 0 | | 1 0 0 1 0 | 233 |
| 0 0 0 1 1 | DON'T CARE | 1 0 0 1 1 | 144 |
| 0 0 1 0 0 | | 1 0 1 0 0 | 89 |
| 0 0 1 0 1 | | 1 0 1 0 1 | 55 |
| 0 0 1 1 0 | | 1 0 1 1 0 | 34 |
| 0 0 1 1 1 | | 1 0 1 1 1 | 21 |
| 0 1 0 0 0 | 28657 | 1 1 0 0 0 | 13 |
| 0 1 0 0 1 | 17711 | 1 1 0 0 1 | 8 |
| 0 1 0 1 0 | 10946 | 1 1 0 1 0 | 5 |
| 0 1 0 1 1 | 6765 | 1 1 0 1 1 | 3 |
| 0 1 1 0 0 | 4181 | 1 1 1 0 0 | 2 |
| 0 1 1 0 1 | 2584 | 1 1 1 0 1 | 1 |
| 0 1 1 1 0 | 1597 | 1 1 1 1 0 | 1 |
| 0 1 1 1 1 | 987 | 1 1 1 1 1 | 0 |

# FIG. 7.

# FIG. 8.

# FIG. 9.

FIG. 10.

# FIG. II.

EP 0 234 070 B1

# FIG. 12.

| ADDRESS $A_4\ A_3\ A_2\ A_1\ A_0$ | "HIGH" PROM $\underline{10}$ $F_{15}\ F_{14}\ F_{13}\ F_{12}\ F_{11}\ F_{10}\ F_9\ F_8$ | "LOW" PROM $F_7\ F_6\ F_5\ F_4\ F_3\ F_2\ F_1\ F_0$ |
|---|---|---|
| 0 0 0 0 0 | | |
| 0 0 0 0 1 | | |
| 0 0 0 1 0 | | |
| 0 0 0 1 1 | DON'T CARE | DON'T CARE |
| 0 0 1 0 0 | | |
| 0 0 1 0 1 | | |
| 0 0 1 1 0 | | |
| 0 0 1 1 1 | | |
| 0 1 0 0 0 | 0 1 1 0 1 1 1 1 | 1 1 1 1 0 0 0 1 |
| 0 1 0 0 1 | 0 1 0 0 0 1 0 1 | 0 0 1 0 1 1 1 1 |
| 0 1 0 1 0 | 0 0 1 0 1 0 1 0 | 1 1 0 0 0 0 1 0 |
| 0 1 0 1 1 | 0 0 0 1 1 0 1 0 | 0 1 1 0 1 1 0 1 |
| 0 1 1 0 0 | 0 0 0 1 0 0 0 0 | 0 1 0 1 0 1 0 1 |
| 0 1 1 0 1 | 0 0 0 0 1 0 1 0 | 0 0 0 1 1 0 0 0 |
| 0 1 1 1 0 | 0 0 0 0 0 1 1 0 | 0 0 1 1 1 1 0 1 |
| 0 1 1 1 1 | 0 0 0 0 0 0 1 1 | 1 1 0 1 1 0 1 1 |
| 1 0 0 0 0 | 0 0 0 0 0 0 1 0 | 0 1 1 0 0 0 1 0 |
| 1 0 0 0 1 | 0 0 0 0 0 0 0 1 | 0 1 1 1 1 0 0 1 |
| 1 0 0 1 0 | 0 0 0 0 0 0 0 0 | 1 1 1 0 1 0 0 1 |
| 1 0 0 1 1 | 0 0 0 0 0 0 0 0 | 1 0 0 1 0 0 0 0 |
| 1 0 1 0 0 | 0 0 0 0 0 0 0 0 | 0 1 0 1 1 0 0 1 |
| 1 0 1 0 1 | 0 0 0 0 0 0 0 0 | 0 0 1 1 0 1 1 1 |
| 1 0 1 1 0 | 0 0 0 0 0 0 0 0 | 0 0 1 0 0 0 1 0 |
| 1 0 1 1 1 | 0 0 0 0 0 0 0 0 | 0 0 0 1 0 1 0 1 |
| 1 1 0 0 0 | 0 0 0 0 0 0 0 0 | 0 0 0 0 1 1 0 1 |
| 1 1 0 0 1 | 0 0 0 0 0 0 0 0 | 0 0 0 0 1 0 0 0 |
| 1 1 0 1 0 | 0 0 0 0 0 0 0 0 | 0 0 0 0 0 1 0 1 |
| 1 1 0 1 1 | 0 0 0 0 0 0 0 0 | 0 0 0 0 0 0 1 1 |
| 1 1 1 0 0 | 0 0 0 0 0 0 0 0 | 0 0 0 0 0 0 1 0 |
| 1 1 1 0 1 | 0 0 0 0 0 0 0 0 | 0 0 0 0 0 0 0 1 |
| 1 1 1 1 0 | 0 0 0 0 0 0 0 0 | 0 0 0 0 0 0 0 1 |
| 1 1 1 1 1 | 0 0 0 0 0 0 0 0 | 0 0 0 0 0 0 0 0 |

FIG. 13.

*FIG. 14.*

## FIG. 15.

## FIG. 16.

EP 0 234 070 B1

# FIG. 17.

A15 A14 A13 A12 A11 A10 A9 A8 A7 A6 A5 A4 A3 A2 A1 A0  B15 B14 B13 B12 B11 B10 B9 B8 B7 B6 B5 B4 B3 B2 B1 B0

23

NO CONN.

| 11 | 15 | 2 | 6 | 12 | 14 | 3 | 5 |
|----|----|---|---|----|----|---|---|

B3 B2 B1 B0 A3 A2 A1 A0

C4  74LS283 4-BIT ADDER  C0

S3  S2  S1  S0

| 10 | 13 | 1 | 4 |

S15 S14 S13 S12

| 11 | 15 | 2 | 6 | 12 | 14 | 3 | 5 |

B3 B2 B1 B0 A3 A2 A1 A0

C4  74LS283 4-BIT ADDER  C0

S3  S2  S1  S0

| 10 | 13 | 1 | 4 |

S11 S10 S9 S8

| 11 | 15 | 2 | 6 | 12 | 14 | 3 | 5 |

B3 B2 B1 B0 A3 A2 A1 A0

C4  74LS283 4-BIT ADDER  C0

S3  S2  S1  S0

| 10 | 13 | 1 | 4 |

S7 S6 S5 S4

| 11 | 15 | 2 | 6 | 12 | 14 | 3 | 5 |

B3 B2 B1 B0 A3 A2 A1 A0

C4  74LS283 4-BIT ADDER  C0

S3  S2  S1  S0

| 10 | 13 | 1 | 4 |

S3 S2 S1 S0

26

## FIG. 18.

DATA AVAILABLE

22

+5

C

LOAD CLOCK

D    PR    Q

74LS74
D-FLIP-FLOP    22'

CLR    Q̄

UNLOAD PULSE

IN

IN

22"    +5

16-BIT REGISTER

CLK    CLR

OUT

OUT

## FIG. 19.

C

CONTROL COMPUTER

FE

FIBONACCI ENCODER

INK JET HEAD

IP

CUT

T

CARD STOCK

# FIG. 20.